# EUROPEAN PATENT APPLICATION

(11) **EP 4 852 701 A1**
(43) Date of publication of application: **09.12.2026**
(21) Application number: 26183038.4
(22) Date of filing: 04.06.2026
(51) Int. Cl.: H10W 40/60

(54) **HEAT TRANSFER ASSEMBLY AND SYSTEM COMPRISING HEAT TRANSFER ASSEMBLY**

(30) Priority: 06.06.2025 US 202563819393 P; 21.05.2026 US 202664071241 P
(71) Applicant: Laird Technologies, Inc., Chesterfield, MO 63017 (US)
(72) Inventor: SONG, Jacob, Chesterfield, 63017 (US); HELMS, John T., Chesterfield, 63017 (US); ZHOU, Pengle, Chesterfield, 63017 (US); KLINE, James E., Chesterfield, 63017 (US)
(74) Representative: Lind Edlund Kenamets Intellectual Property AB

(57) **Abstract**

Heat transfer assemblies and systems comprising heat transfer assemblies are disclosed. Exemplary embodiments are disclosed of thermal interface solutions for sliding surfaces. In an exemplary embodiment, a fully recoverable slidable heat transfer assembly or thermal interface material (TIM) assembly includes a wear-resistant layer for preserving and improving durability of the thermal interface material when used between sliding components. The heat transfer assembly may comprise a mechanically compliant structure defining a dimensional tolerance compliance envelope corresponding to a predefined tolerance range. The dimensional tolerance compliance envelope is configured to accommodate dimensional variation. And the heat transfer assembly is configured to maintain thermal contact with a thermal transfer surface across the predefined tolerance range.

## Description

### Field

The present disclosure generally relates to thermal interface solutions for sliding surfaces.

### Background

This section provides background information related to the present disclosure which is not necessarily prior art.

Electrical components, such as semiconductors, integrated circuit packages, transistors, *etc.,* typically have pre-designed temperatures at which the electrical components optimally operate. Ideally, the pre-designed temperatures approximate the temperature of the surrounding air. But the operation of electrical components generates heat. If the heat is not removed, the electrical components may then operate at temperatures significantly higher than their normal or desirable operating temperature. Such excessive temperatures may adversely affect the operating characteristics of the electrical components and the operation of the associated device.

To avoid or at least reduce the adverse operating characteristics from the heat generation, the heat should be removed, for example, by conducting the heat from the operating electrical component to a heat sink or cold plate. The heat sink or cold plate may then be cooled by conventional convection and/or radiation techniques. During conduction, the heat may pass from the operating electrical component to the heat sink or cold plate either by direct surface contact between the electrical component and heat sink or cold plate and/or by contact of the electrical component and heat sink/cold plate surfaces through an intermediate medium or thermal interface material (TIM). The thermal interface material may be used to fill the gap between thermal transfer surfaces, in order to increase thermal transfer efficiency as compared to having the gap filled with air, which is a relatively poor thermal conductor.

### Drawings

The drawings described herein are for illustrative purposes only of selected embodiments and not all possible implementations, and are not intended to limit the scope of the present disclosure.

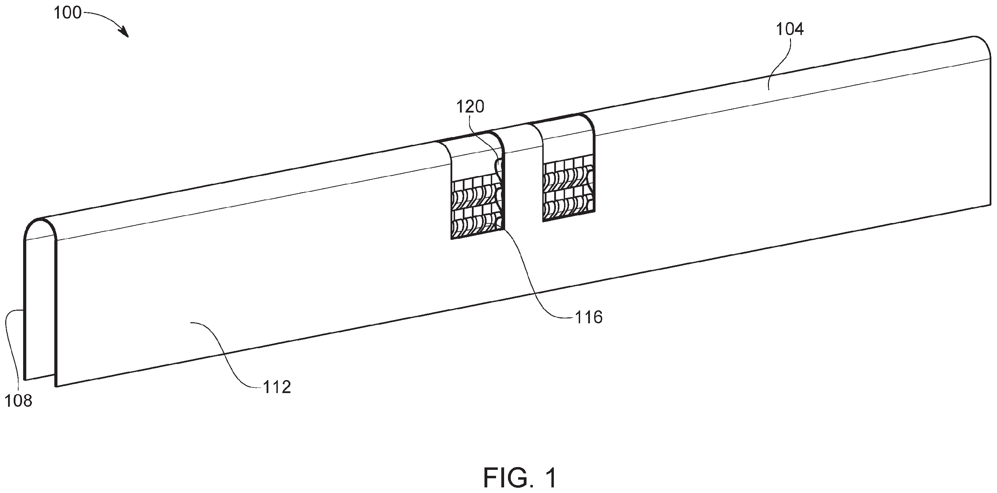

FIG. 1 is a perspective view illustrating a heat transfer assembly (e.g., a thermal interface material (TIM) assembly, *etc.)* suitable for use between sliding components of a device according to an exemplary embodiment of the present disclosure.

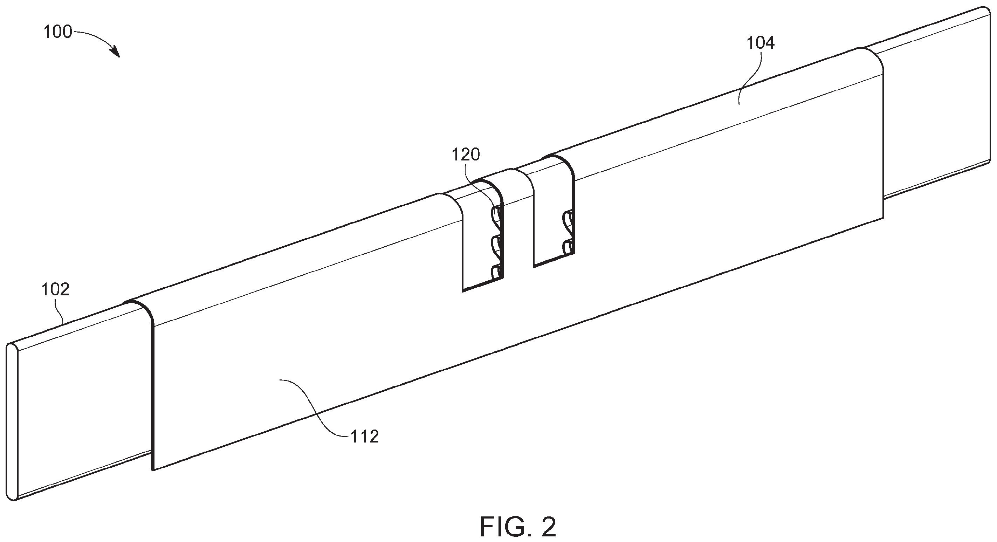

FIG. 2 is another perspective view of the heat transfer assembly shown in FIG. 1 installed on *(e.g.,* draped over, *etc.)* a component *(e.g.,* heat sink, cold plate, substrate, other heat dissipating/removal structure, active/passive cooling structure, *etc.)* according to an exemplary embodiment of the present disclosure.

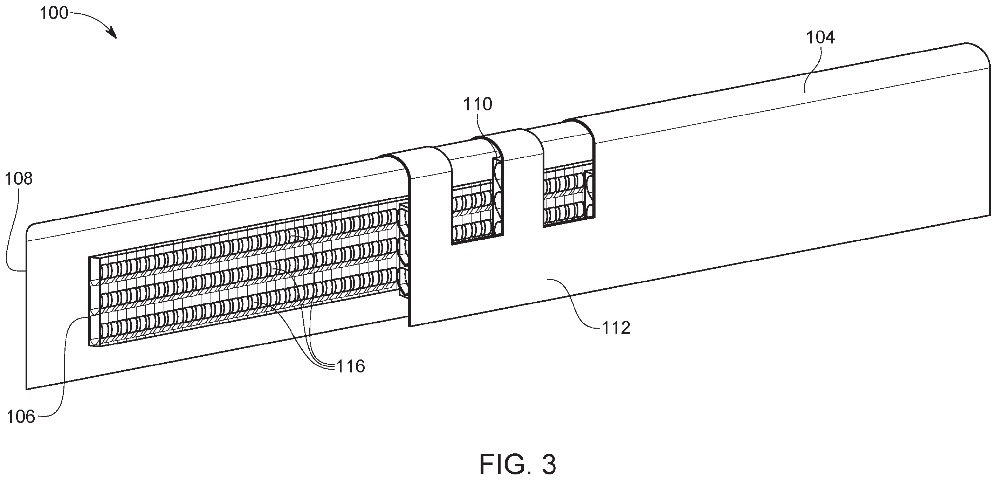

FIG. 3 is another perspective view of the heat transfer assembly shown in FIG. 1 wherein a portion of the wear-resistant layer is not shown in order to illustrate the first and second thermal interface materials and first and second resilient contact elements *(e.g.,* spring-back elements, *etc.)* along the respective first and second wear-resistant side portions of the wear-resistant layer.

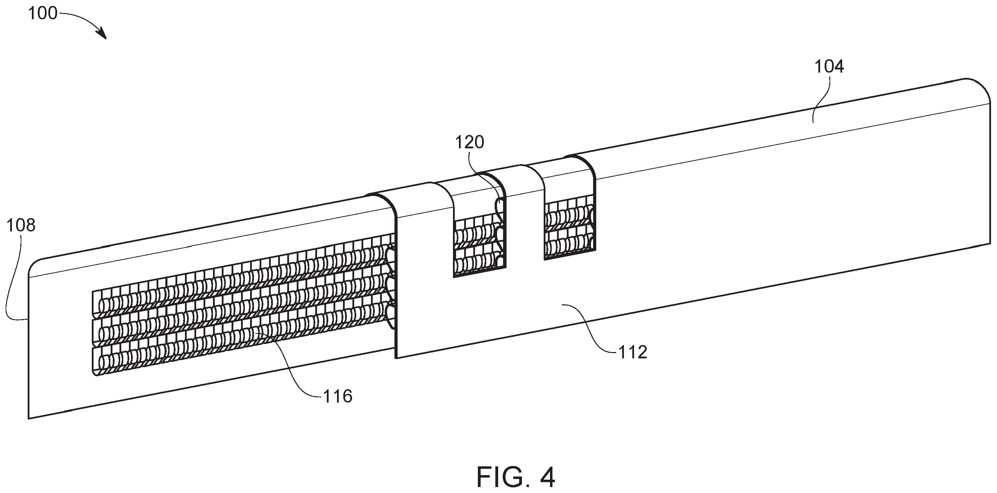

FIG. 4 is another perspective view of the heat transfer assembly shown in FIG. 3 wherein a portion of the wear-resistant layer and thermal interface materials are not shown in order to illustrate the first and second resilient contact elements *(e.g.,* spring-back elements, *etc.)* along the inner surfaces of the respective first and second wear-resistant side portions of the wear-resistant layer.

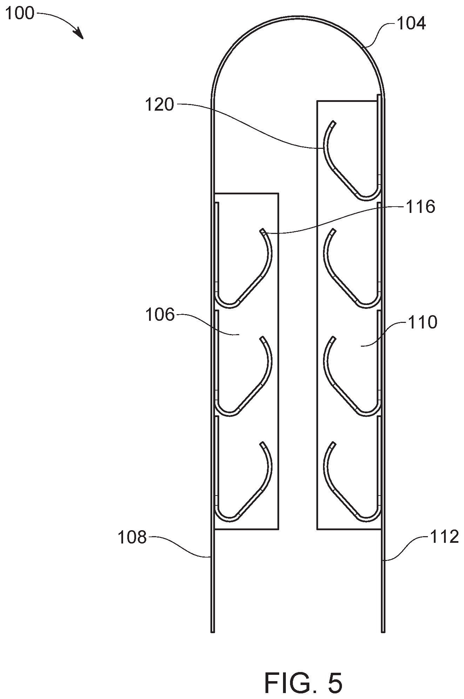

FIG. 5 is an end view of the heat transfer assembly shown in FIG. 1 illustrating the first and second thermal interface materials and the first and second resilient contact elements along the respective first and second wear-resistant side portions of the wear-resistant layer.

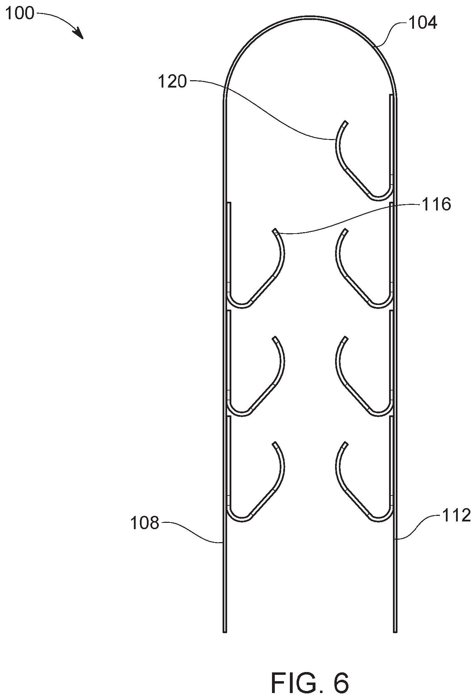

FIG. 6 is another end view of the heat transfer assembly shown in FIG. 5 without the thermal interface materials and illustrating the first and second resilient contact elements along the inner surfaces of the respective first and second wear-resistant side portions of the wear-resistant layer.

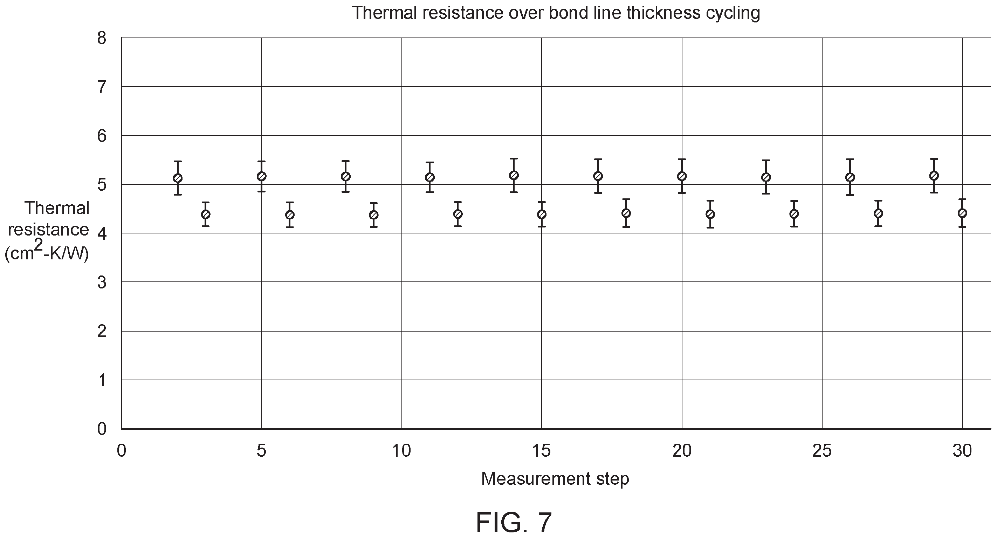

FIG. 7 includes a graph illustrating example thermal resistance (cm²-K/W) over bond line thickness cycling achievable with exemplary embodiments of the heat transfer assemblies disclosed herein.

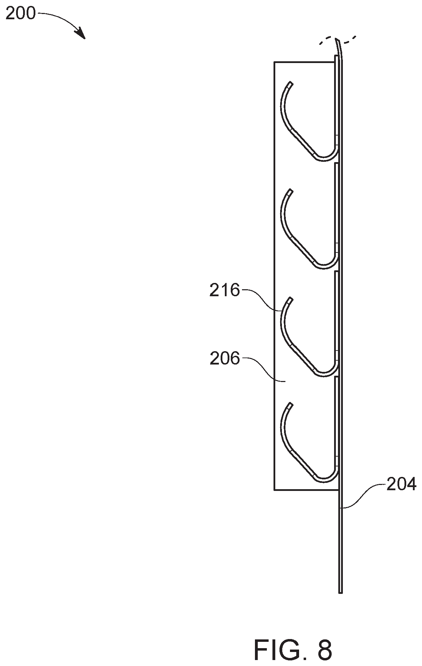

FIG. 8 is an end view of a heat transfer assembly (*e*.*g*., a non-draped version of a TIM assembly for single-sided heat dissipation, *etc.)* according to an exemplary embodiment of the present disclosure. FIG. 8 illustrates a thermal interface material and resilient contact elements along an inner surface of a wear-resistant layer.

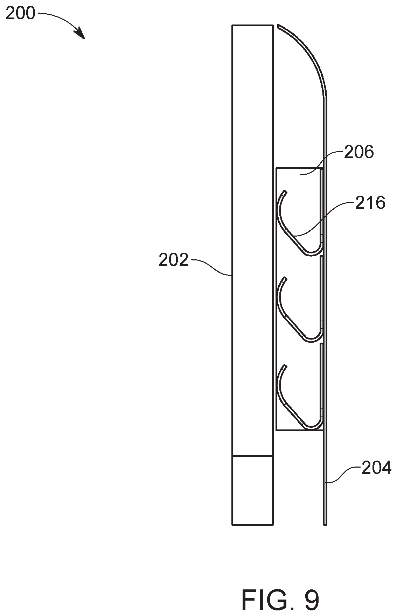

FIG. 9 is another end view of the heat transfer assembly shown in FIG. 8 installed on *(e.g.,* draped over, *etc.)* a component *(e.g.,* heat sink, cold plate, substrate, other heat dissipating/removal structure, active/passive cooling structure, *etc.)* according to an exemplary embodiment of the present disclosure.

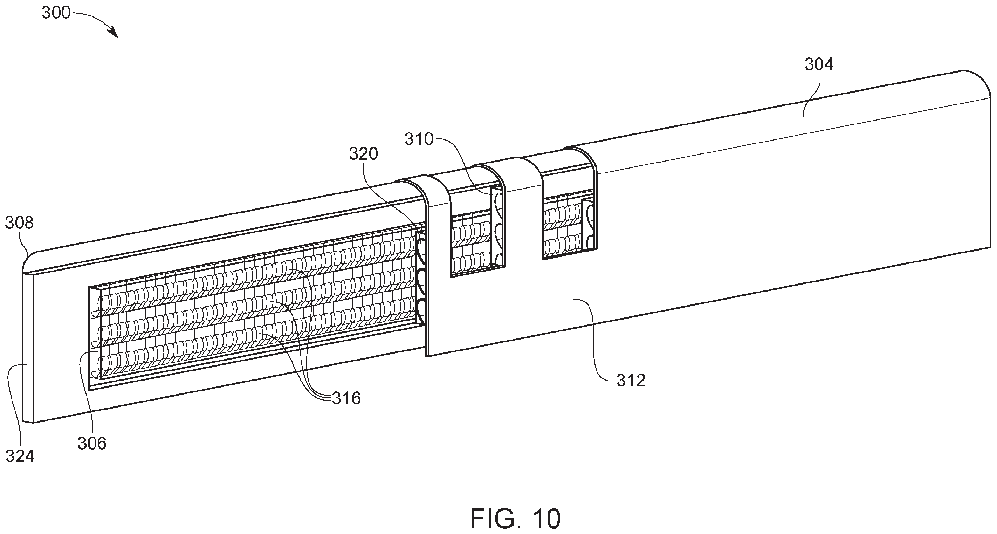

FIG. 10 is a perspective view of a heat transfer assembly *(e.g.,* a TIM assembly, *etc.)* according to an exemplary embodiment of the present disclosure. A portion of the wear-resistant layer is not shown in order to illustrate the first and second thermal interface materials, and first and second resilient contact elements *(e.g.,* spring-back elements, *etc.)* along the respective first and second wear-resistant side portions of the wear-resistant layer. In this exemplary embodiment, seals are disposed around perimeter edges of the first and second thermal interface materials. The seals are configured to inhibit migration of the thermal interface materials and retain the thermal interface material within the heat transfer assembly. By way of example, the seal(s) may comprise foam, elastomer, tape, or film, *etc.* Or the seal(s) may be provided as an integrated seal function in component/system design.

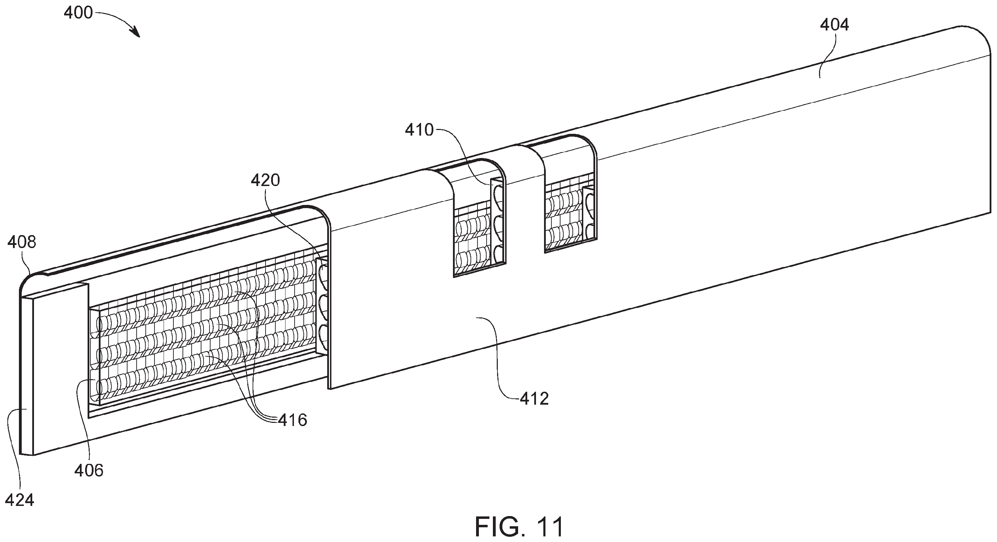

FIG. 11 is a perspective view of a heat transfer assembly *(e.g.,* a TIM assembly, *etc.)* according to an exemplary embodiment of the present disclosure. A portion of the wear-resistant layer is not shown in order to illustrate the first and second thermal interface materials, and first and second resilient contact elements *(e.g.,* spring-back elements, *etc.)* along the respective first and second wear-resistant side portions of the wear-resistant layer. In this exemplary embodiment, seals are disposed around bottom and side perimeter edges (but not the top perimeter edges) of the first and second thermal interface materials. The seals are configured to inhibit migration of the thermal interface materials and retain the thermal interface material within the heat transfer assembly. By way of example, the seal(s) may comprise foam, elastomer, tape, or film, *etc.* Or the seal(s) may be provided as an integrated seal function in component/system design.

Corresponding reference numerals may indicate corresponding (though not necessarily identical) parts throughout the several views of the drawings.

### Detailed Description

Example embodiments will now be described more fully with reference to the accompanying drawings.

Exemplary embodiments are disclosed of thermal interface solutions for sliding surfaces. The disclosed thermal interface solutions are configured to withstand insertions of heat dissipating modules and recover after removal, thereby ensuring repeatable thermal resistance over numerous insertion and removal cycles.

In exemplary embodiments, a fully recoverable slidable thermal interface material (TIM) assembly or heat transfer assembly includes a wear-resistant layer for preserving and improving durability of the thermal interface material when used between sliding components. For example, the heat transfer may be between a dynamic random-access memory (DRAM) component on a fifth generation double data rate (DDR5) dual in-line memory module (DIMM) and a heat sink, cold plate, active/passive cooling structure (*e*.*g*., liquid cold plate, manifold, vapor chamber, heat pipe, thermal rail, chassis-integrated cooling structure, *etc*.)*,* other heat dissipating/removal structure, *etc.*

In exemplary embodiments, the heat transfer assembly or TIM assembly includes a thermal interface material that may be installed on a heat sink, cold plate, active/passive cooling structure (*e.g.,* liquid cold plate, manifold, vapor chamber, heat pipe, thermal rail, chassis-integrated cooling structure, *etc*.)*,* other heat dissipating/removal structure, *etc.* The heat transfer assembly or TIM assembly includes a wear-resistant layer to preserve and improve durability of the thermal interface material as the heat source slides in and out of position relative to the heat sink, cold plate, active/passive cooling structure, other heat dissipating/removal structure, *etc.* on which the heat transfer assembly or TIM assembly is installed. The heat source may comprise DRAM component on a DDR5 DIMM, hot-swappable or slidably insertable data center modules requiring thermal coupling to an active or passive cooling structure, OSFP-RHS/OSFP/QSFP/SFP optical modules, E1.S/E1.L/E3.S/E3.L storage and memory modules, SSDs, CXL memory, accelerator modules, networking modules, power modules, other field-replaceable modules that slidably engage a cooling structure, other heat source, *etc.*

Thermal interface material may be disposed, dispense, or applied to the inside of the wear-resistant layer. The thermal interface material may have a high thermal conductivity, *e.g.,* within a range from about 1 Watt per meter per Kelvin (W/mK) to about 50 W/mK as determined by ASTM D5470. In combination with the thermal interface material installed under the wear-resistant layer, the heat transfer assembly or TIM assembly also includes spring-back elements (broadly, resilient contact elements) that provide spring back functionality and that resiliently urge or push the wear-resistant layer and thermal interface material into place after the heat source is removed.

The spring-back elements or components also provide thermal transfer paths through the thermal interface material. When the heat source is inserted into position, heat is conducted through the wear-resistant layer, the thermal interface material, and the spring-back components simultaneously and into the heat sink, cold plate, active/passive cooling structure (*e*.*g*., liquid cold plate, manifold, vapor chamber, heat pipe, thermal rail, chassis-integrated cooling structure, *etc*.)*,* other heat dissipating/removal structure, *etc.*

Advantageously, exemplary embodiments of the heat transfer assemblies disclosed herein (*e.g.,* TIM assembly 100 (FIGS. 1-6), 200 (FIG. 8), 300 (FIG. 10), 400 (FIG. 11), *etc.*) may provide one or more (but not necessarily any or all) of the following advantages. For example, the heat transfer assemblies or TIM assemblies disclosed herein may fix tearing issues with previous iterations of wear-resistant layers and provide increased durability during insertions. The heat transfer assemblies or TIM assemblies disclosed herein may improve reusability with spring-back properties that provide repeatable thermal performance over many insertions. The heat transfer assemblies or TIM assemblies disclosed herein may provide low thermal resistance for a sliding interface thermal interface material.

In addition to durability over repeated insertions, the heat transfer assemblies disclosed herein (*e.g.,* TIM assembly 100 (FIGS. 1-6), 200 (FIG. 8), 300 (FIG. 10), 400 (FIG. 11), *etc.*) disclosed herein may also be used to mitigate and accommodate tolerance stack-up, module-to-module dimensional variation, port-to-port variation, surface non-flatness, bow/warp, coplanarity error, and variable bond line thickness while maintaining thermal contact. Advantageously, the resilient heat transfer assemblies disclosed herein can provide a tolerance/compliance window (*e*.*g*., ±0.10 mm, ±0.15 mm, ±0.20 mm, ±0.25 mm, greater than ±0.25 mm, a tolerance/compliance window between ±0.10 mm and ±0.25 mm, *etc.*) allowing design engineers to simplify port and module tolerancing while maintaining reliable thermal contact. For example, the dimensional tolerance compliance envelope may correspond to a dimensional tolerance range of a component against ±0 to 5 mm height discrepancy to thereby accommodate different component heights from ±0 to 10 mm.

With reference to the figures, FIGS. 1 through 6 illustrate a heat transfer assembly or thermal interface material (TIM) assembly 100 suitable for use between sliding components of a device according to an exemplary embodiment of the present disclosure. As shown, the TIM assembly 100 includes a wear-resistant layer 104 having opposite first and second wear-resistant side portions 108, 112 for respectively covering thermal interface material(s).

The wear-resistant layer 104 may have a draped design that allows for mounting on a cold plate/thermal solution. For example, FIG. 2 shows the TIM assembly 100 draped over (broadly, installed on) a component 102, such as a heat sink, cold plate, substrate, active/passive cooling structure (*e.g.,* liquid cold plate, manifold, vapor chamber, heat pipe, thermal rail, chassis-integrated cooling structure, *etc.*), other heat dissipating/removal structure, *etc.* In other exemplary embodiments, the TIM assembly 100 may be used as a single-sided application in which the TIM assembly 100 is installed along a single side of (and not draped over) a component, such as an optical module, *etc.*

As shown in FIGS. 3 and 5, first and second thermal interface materials 106, 110 and first and second resilient contact elements 116, 120 (*e.g.,* spring-back elements, *etc*.) are along (*e.g.,* inner surfaces of, *etc.)* the respective first and second wear-resistant side portions 108, 112 of the wear-resistant layer 104.

By way of example, the first and second resilient contact elements 116, 120 may be bonded (*e*.*g*., via thermally-conductive adhesive, soldering, any other material that provides some level of adhesive and can conduct heat, *etc*.) to the respective first and second wear-resistant side portions 108, 112 of the wear-resistant layer 104. Additionally, or alternatively, the first thermal interface material 106 and/or the second thermal interface material 110 may be naturally tacky and/or self-adherent such that the thermal interface materials are sufficiently tacky and/or self-adherent to be used as the bonding agents for bonding the first and second resilient contact elements 116, 120 to the respective first and second wear-resistant side portions 108, 112 of the wear-resistant layer 104.

The first and second thermal interface materials 106, 110 may comprise the same material or different materials, and are selected to facilitate thermal coupling between adjacent components while accommodating mechanical tolerances and surface irregularities. In various embodiments, the first and/or second thermal interface materials 106, 110 may include, without limitation, compressible thermal pads, gels, putties, greases, phase-change materials, cure-in-place or form-in-place materials, or dispensable thermal interface materials. The thermal interface materials may further include advanced material classes such as liquid metals or liquid metal-filled compositions, graphite or other carbon-based thermal interface materials, ceramic-filled polymer systems, and both electrically insulating and electrically conductive formulations. In some implementations, the thermal interface materials may comprise hybrid structures, including stacked or layered combinations of multiple materials, or materials engineered to exhibit anisotropic thermal conductivity in one or more directions. These materials may be provided in solid, semi-solid, gel, or liquid form, and may be configured to provide conformability, gap-filling capability, thermal conductivity, and long-term stability under operational and environmental conditions.

The TIM assembly 100 is positionable generally between a first component and a second component slidable relative to the first component such that the first wear-resistant side portion 108 of the wear-resistant layer 104 is between the first thermal interface material 106 and a first surface of the first component and such that the second wear-resistant side portion 112 of the wear-resistant layer 104 is between the second thermal interface material 110 and a second surface of the second component. The first and second resilient contact elements 116, 120 are configured to be operable for providing spring back functionality for urging the wear-resistant layer 104 and the respective first and second thermal interface materials 106, 110 into their initial positioning after the first and second surfaces of the respective first and second components are slidably moved relative to each other.

The first and second resilient contact elements 116, 120 are thermally-conductive and configured to be operable for providing thermally-conductive heat paths between the wear-resistant layer 104 and the respective first and second thermal interface material 106, 110.

The first thermal interface material 106 may be disposed, dispensed, or applied along and over the first resilient contact element(s) 116 such that the first resilient contact element(s) 116 are covered by and/or embedded within the first thermal interface material 106. Similarly, the second thermal interface material 110 may be disposed, dispensed, or applied along and over the second resilient contact element(s) 120 such that the second resilient contact element(s) 120 are covered by and/or embedded within the second thermal interface material 110.

The wear-resistant layer 104 may be configured to be draped over a heat sink, cold plate, substrate, active/passive cooling structure (*e*.*g*., liquid cold plate, manifold, vapor chamber, heat pipe, thermal rail, chassis-integrated cooling structure, *etc.*), or heat dissipating/removal structure such that the wear-resistant layer 104 extends over and along an upper surface and first and second sides of the heat sink, cold plate, substrate, active/passive cooling structure, or heat dissipating/removal structure. The wear-resistant layer 104 may define a generally inverted U-shape over the heat sink, cold plate, substrate, active/passive cooling structure, or heat dissipating/removal structure.

As shown in FIGS. 5 and 6, the wear-resistant layer 104 may define a generally inverted U-shape. The first resilient contact elements 116 may comprise a plurality of upwardly facing generally U-shaped resilient contact elements spaced apart along the inner surface of the first wear-resistant side portion 108 of the wear-resistant layer 104. The second resilient contact elements 120 may comprise a plurality of upwardly facing generally U-shaped resilient contact elements spaced apart along the inner surface of the second wear-resistant side portion 112 of the wear-resistant layer 104.

The first and second resilient contact elements 116, 120 are configured to be operable for providing spring back functionality for urging and/or retaining the wear-resistant layer 104 and the respective first and second thermal interface materials 106, 110 into their initial positioning after the first component has been slidably removed from the device. And the first and second resilient contact elements 116, 120 are configured to be operable for providing spring back functionality for urging and/or retaining the wear-resistant layer 104 and the respective first and second thermal interface material 106, 110 into their initial positioning after the first component has been slidably inserted into position within the device.

The wear-resistant layer 104 may have a thickness within a range from about 10 microns to about 300 microns, *etc.* Various materials may be used for the wear-resistant layer 104. For example, the wear-resistant layer 104 may comprise a polyimide-copper clad material in which the polyimide is deposited directly on or bonded to a surface of the copper. Or, for example, the wear-resistant layer 104 may comprise a metal foil or film (or other electrically-conductive foil or film) with or without an electrically-insulating layer thereon. As yet another example, the wear-resistant layer 104 may comprise a copper clad, stainless steel clad, steel clad, or other metal clad having a thickness within a range from about 10 microns to about 250 microns, and an electrically-insulating material thereon having a thickness within a range from about 7.5 microns to about 100 microns. In another example, the wear-resistant layer 104 may comprise a copper foil, a stainless steel foil, a metal foil, or a non-metal foil or film that is tear resistant and puncture resistant and that has a thickness within a range from about 10 microns to 250 microns. In yet a further example, the wear-resistant layer 104 may comprise a non-metal foil that is tear resistant and puncture resistant and that has a high thermal conductivity and a thickness within a range from about 10 microns to 250 microns.

In exemplary embodiments, the wear-resistant layer 104 may include or be formed from a variety of materials configured to provide durability, thermal performance, and, in some implementations, electrical functionality. Such materials may include, without limitation, metals, metal alloys, plated metals, metalized films, graphite, carbon-based materials, thermally conductive polymers, ceramic-filled polymers, hybrid laminates, and electrically insulating yet thermally conductive structures. By way of further example, suitable material classes for the wear-resistant layer 104 may include: aluminum and aluminum alloys; nickel, nickel plating, and chromium coatings; brass, bronze, and copper alloys; titanium and titanium alloys; spring steel and stainless spring steel; beryllium copper and phosphor bronze; metalized polymer films; polymer films such as polyimide (PI), polyethylene terephthalate (PET), polyethylene naphthalate (PEN), polytetrafluoroethylene (PTFE), polyether ether ketone (PEEK), polyphenylene sulfide (PPS), liquid crystal polymer (LCP), and fluoropolymers; diamond-like carbon (DLC)-coated films or foils; ceramic-coated metal foils; anodized metal foils; graphite materials including graphite sheets, pyrolytic graphite, and expanded graphite; carbon fiber materials or carbon-filled films; thermally conductive polymer composites; and electrically insulating, thermally conductive laminates. These materials may be used individually or in combination and may be provided as films, foils, sheets, coatings, laminates, or composite structures, optionally including surface treatments or coatings to enhance wear resistance, thermal conductivity, corrosion resistance, or interfacial performance. The wear-resistant layer may comprises graphite and/or non-metallic high thermal conductivity material.

By way of example, the first and second resilient contact elements 116, 120 may comprise stamped resilient contact elements (*e.g.,* stamped U-shaped springs, *etc.*). For example, the first and second resilient contact elements 116, 120 may be stamped from materials such as stainless steel, beryllium copper, other metal material, or non-metal material. Or, for example, the first and second resilient contact elements 116, 120 may comprise foam resilient contact elements, fabric-over-foam (FOF) resilient contact elements, graphite-over-foam (GOF) resilient contact elements, or elastomeric resilient contact elements. As yet another example, the first and second resilient contact elements 116, 120 may comprise one or more polymeric materials.

By way of further example, the first and second resilient contact elements 116, 120 may comprise any structure configured to elastically deform under load and at least partially recover upon load removal. Such structures may include, without limitation, one or more leaf springs, wave springs, cantilever springs, dome or Belleville springs, coil springs, corrugated or pleated members, ribs, serpentine elements, spring fingers, compressible foams, elastomeric bodies, conductive meshes, graphite or composite compressible structures, woven, knitted, braided, or nonwoven conductive structures, compressible lattice or cellular structures (including honeycomb configurations), additively manufactured microstructures, etched features, or integral spring features formed in or coupled to a wear-resistant layer 104, carrier, cage, cold plate, chassis, or module.

As used herein, the term "resilient contact element" is intended to be construed broadly to encompass any structure or feature capable of elastically deforming under load and at least partially recovering upon load removal, and of providing one or more functional characteristics including elastic compression, recovery or restoring force, localized force application, gap-filling compliance, thermal conduction across an interface, mechanical load distribution, and restoration of an original or nominal shape following insertion, removal, or repeated engagement. Such resilient contact elements (*e*.*g*., 116, 120, 216, 316, 320, *etc.*) may be formed from a wide range of material classes selected to provide desired combinations of electrical conductivity, thermal conductivity, elasticity, durability, and environmental resistance, including, without limitation: metals and metal alloys such as copper alloys, nickel alloys, aluminum alloys, titanium alloys, phosphor bronze, spring steel, stainless steel, and beryllium copper; conductive elastomers; elastomeric materials including silicone, fluorosilicone, polyurethane, ethylene propylene diene monomer (EPDM), and thermoplastic elastomers; elastomers filled with conductive or thermally conductive additives such as graphite, carbon, ceramic, or metal fillers; metal foams, graphite foams, carbon foams, and polymer foams incorporating conductive fillers; woven, knitted, braided, or mesh structures formed from metal or graphite; and hybrid materials including metal-polymer composites. The foregoing materials may be used individually or in combination and may optionally include plated, coated, or otherwise surface-treated configurations to enhance electrical conductivity, thermal performance, corrosion resistance, wear characteristics, or contact reliability.

In various embodiments, and without limitation, the resilient contact elements may take the form of any of the following configurations: leaf springs; wave springs; cantilever springs; Belleville springs, dome springs, or disk springs, corrugated or pleated structures; serpentine structures; arched ribs or beams; structures having C-shaped, S-shaped, W-shaped, V-shaped, Ω-shaped, U-shaped, Z-shaped, or sinusoidal geometries; coil springs, including micro-coils; spring fingers or compliant contact fingers; stamped or formed contact arrays; lanced and formed metal features; compressible posts, pillars, ribs, bumps, domes, or islands; lattice, cellular, or honeycomb structures; conductive foam bodies or strips; conductive elastomeric elements; graphite foams, graphite sheet stacks, or expanded graphite structures; woven, knitted, braided, mesh, or nonwoven conductive structures; and/or additively manufactured, etched, or otherwise micro-fabricated spring structures.

In some embodiments, the resilient contact elements need not be discrete components. Rather, the resilient functionality may be provided by features integrated within one or more system components. For example, and without limitation, the resilient contact elements may be implemented as: one or more integrated spring features formed within a primary structural component; one or more separate spring components inserted or positioned between adjacent elements; one or more spring structures bonded, affixed, or otherwise coupled to the wear-resistant layer; one or more spring structures embedded within a thermal interface material (TIM); one or more spring structures formed integrally with the wear-resistant layer; and/or one or more spring structures formed integrally with a carrier, foil, cage, chassis, cold plate, module surface, or other supporting structure.

The TIM assembly 100 may include first and second thermal interface materials 106, 110 having high thermal conductivities, *e.g.,* within a range from about 1 Watt per meter per Kelvin (W/mK) to about 50 W/mK as determined by ASTM D5470. The first and/or second thermal interface materials may comprise a thermal gel, a thermal gap filler pad, a thermal phase change material, a thermal putty, a thermal grease, and/or a dispensable thermal interface material.

In exemplary embodiments, the TIM assembly 100 is used between first and second components of a device that are slidable relative to each other. The first component may comprise a heat source of the device. The second component may comprise a heat sink, cold plate, active/passive cooling structure, or other heat dissipating/removal structure. In such exemplary embodiments, the first and second resilient contact elements 116, 120 are operable for providing spring back functionality for urging the wear-resistant layer 104 and the respective first and second thermal interface materials into their initial positioning after the heat source has been slidably removed from the device.

The first and second resilient contact elements 116, 120 are also operable for providing spring back functionality for urging the wear-resistant layer 104 and the respective first and second thermal interface materials 106, 110 into their initial positioning after the heat source has been slidably inserted into position within the device. At which point, a thermally-conductive heat path or thermal joint is defined from the heat source through the wear-resistant layer 104, the first and second resilient contact elements 116, 120, and the first and second thermal interface materials 106, 110 to the heat sink, cold plate, active/passive cooling structure, or other heat dissipating/removal structure.

In exemplary embodiments, the first wear-resistant side portion 108 of the wear-resistant layer 104 is configured to slide along and in contact with the first surface of the first component when the TIM assembly 100 is along the second surface of the second component and when the first and second surfaces of the respective first and second components are slidably moved relative to each other. Additionally, or alternatively, the second wear-resistant side portion 112 of the wear-resistant layer 104 is configured to slide along and in contact with the second surface of the second component when the TIM assembly 100 is along the first surface of the first component and when the first and second surfaces of the respective first and second components are slidably moved relative to each other.

In exemplary embodiments in which the TIM assembly 100 is used between first and second components of a device that are slidable relative to each other, the first component may comprise a dynamic random-access memory (DRAM) component on a fifth generation double data rate (DDR5) dual in-line memory module (DIMM). And the second component may comprise a heat sink, cold plate, active/passive cooling structure, or other heat dissipating/removal structure.

In exemplary embodiments, the TIM assembly 100 is configured to provide one or more of: increased durability for withstanding insertions of a heat dissipating module and recover after removal, ensuring repeatable thermal resistance over numerous insertion and removal cycles; improved reusability with spring-back properties that enable repeatable thermal performance over many insertions; and low thermal resistance for a sliding interface thermal interface material.

In exemplary embodiments, the wear-resistant layer 104 is configured to have a lower coefficient of friction than the first and second thermal interface materials.

FIG. 7 includes a graph illustrating example thermal resistance (cm²-K/W) over bond line thickness cycling achievable with exemplary embodiments of the heat transfer assemblies (e.g., TIM assembly 100 (FIG. 1), *etc*.) disclosed herein. In this example, the resulting thermal performance is <6 cm²-°C/W for a 10mm x 10mm area (approximately the size of a DRAM component on a DDR5 DIMM). Thermal performance does not degrade when the bond line thickness is cycled between 1.1, 1.0 mm, and released to 1.4mm at the beginning of each cycle when measured on an ASTM D5470 thermal resistance test fixture.

FIG. 8 is an end view of a heat transfer assembly or TIM assembly 200 according to an exemplary embodiment of the present disclosure. FIG. 8 illustrates a thermal interface material 206 and resilient contact elements 216 along an inner surface of a wear-resistant layer 204. In this exemplary embodiment, the TIM assembly 200 has a non-draped configuration or single-sided heat dissipation. As shown in FIG. 9, the TIM assembly 200 is installed on (*e.g.,* draped over, *etc*.) a component 202 (*e.g.,* heat sink, cold plate, substrate, other heat dissipating/removal structure, active/passive cooling structure, *etc.*).

The wear-resistant layer 204, thermal interface material 206, and resilient contact elements 216 of the TIM assembly 200 may be similar or essentially identical to the corresponding wear-resistant layer 104, thermal interface material 106, and resilient contact elements 116 of the TIM assembly 100 as described above. Thus, the discussion of the wear-resistant layer 204, thermal interface material 206, and resilient contact elements 216 of the TIM assembly 200 is abbreviated and not repeated for the sake of brevity.

In some exemplary embodiments, a seal (*e.g.,* seal 324 (FIG. 10), seal 424 (FIG. 11), *etc.)* is disposed around perimeter edges of thermal interface material 206. The seal may extend continuously along the perimeter of the thermal interface material 206. Or, for example, the seal may be disposed around side and bottom perimeter edges of the thermal interface materials 206. But in this latter example, the seal does not extend along the top perimeter edge of the thermal interface material 206. In both examples above, the seal is configured to inhibit migration of the thermal interface material 206 and retain the thermal interface material within the TIM assembly 200. By way of example, the seal may comprise foam, elastomer, tape, or film, *etc.* Or the seal may be provided as an integrated seal function in component/system design.

FIG. 10 is a perspective view of a heat transfer assembly or TIM assembly 300 according to an exemplary embodiment of the present disclosure. A portion of the wear-resistant layer 304 is not shown in order to illustrate the first and second thermal interface materials 306, 310, and first and second resilient contact elements 316, 320 (*e.g.,* spring-back elements, *etc.)* along the respective first and second wear-resistant side portions 308, 312 of the wear-resistant layer 304.

In this exemplary embodiment, a first seal 324 and a second seal are disposed around perimeter edges of the respective first and second thermal interface materials 306, 310. In this exemplary embodiment, the first and second seals may extend continuously along the perimeter of the respective first and second thermal interface material 306, 310. The first and second seals are configured to inhibit migration of the respective thermal interface materials 306, 310 and retain the thermal interface material within the TIM assembly 300. By way of example, the first and second seals may comprise foam, elastomer, tape, or film, *etc.* Or the first and second seals may be provided as an integrated seal function in component/system design.

The wear-resistant layer 304, first and second thermal interface materials 306, 310, and first and second resilient contact elements 316, 320 of the TIM assembly 300 may be similar or essentially identical to the corresponding wear-resistant layer 104, first and second thermal interface materials 106, 110, and first and second resilient contact elements 116, 120 of the TIM assembly 100 as described above. Thus, the discussion of the wear-resistant layer 304, first and second thermal interface materials 306, 310, and first and second resilient contact elements 316, 320 of the TIM assembly 300 is abbreviated and not repeated for the sake of brevity.

FIG. 11 is a perspective view of a heat transfer assembly or TIM assembly 400 according to an exemplary embodiment of the present disclosure. A portion of the wear-resistant layer 404 is not shown in order to illustrate the first and second thermal interface materials 406, 410, and first and second resilient contact elements 416, 420 (*e.g.,* spring-back elements, *etc*.) along the respective first and second wear-resistant side portions 408, 412 of the wear-resistant layer 404.

In this exemplary embodiment, a first seal 424 and a second seal are disposed around side and bottom perimeter edges of the respective first and second thermal interface materials 406, 410. But in this exemplary embodiment, the first and second seals do not extend along the top perimeter edges of the respective first and second thermal interface material 406, 410. The first and second seals are configured to inhibit migration of the respective thermal interface materials 406, 410 and retain the thermal interface material within the TIM assembly 400. By way of example, the first and second seals may comprise foam, elastomer, tape, or film, *etc.* Or the first and second seals may be provided as an integrated seal function in component/system design.

The wear-resistant layer 404, first and second thermal interface materials 406, 410, and first and second resilient contact elements 416, 420 of the TIM assembly 400 may be similar or essentially identical to the corresponding wear-resistant layer 104, first and second thermal interface materials 106, 110, and first and second resilient contact elements 116, 120 of the TIM assembly 100 as described above. Thus, the discussion of the wear-resistant layer 404, first and second thermal interface materials 406, 410, and first and second resilient contact elements 416, 420 of the TIM assembly 400 is abbreviated and not repeated for the sake of brevity.

In exemplary embodiments, the thermal interface material has a thermal conductivity within a range from about 1 Watt per meter per Kelvin (W/mK) to about 50 W/mK as determined by ASTM D5470.

In addition to durability over repeated insertions, the heat transfer assemblies (*e*.*g*., TIM assembly 100 (FIGS. 1-6), 200 (FIG. 8), 300 (FIG. 10), 400 (FIG. 11), *etc*.) are configured with a mechanical compliance architecture to mitigate and/or accommodate tolerance stack-up, gap variation, module-to-module dimensional variation, port-to-port dimensional variation, surface non-flatness, cold plate / heatsink / module non-flatness, bow/warp, coplanarity error, tilt, step height, surface roughness, and variable bond line thickness while maintaining thermal contact. The mechanical compliance architecture of the heat transfer assembly may enable the heat transfer assembly to maintain thermal performance after repeated insertion/removal despite dimensional tolerance variation. The mechanical compliance architecture of the heat transfer assembly may also reduce system-level design burden by allowing a defined insertion envelope or tolerance window. Advantageously, the resilient heat transfer assemblies disclosed herein can provide a tolerance/compliance window (*e*.ig., ±0.10 mm, ±0.15 mm, ±0.20 mm, ±0.25 mm greater than ±0.25 mm, a tolerance/compliance window between 0.10 mm and 0.25 mm *etc*.) allowing design engineers to simplify port and module tolerancing while maintaining reliable thermal contact. For example, the dimensional tolerance compliance envelope may correspond to a dimensional tolerance range of a component against ±0 to 5 mm height discrepancy to thereby accommodate different component heights from ±0 to 10 mm. In exemplary embodiments, a system comprises a plurality of module ports. Each port includes a thermal interface material assembly having a compliant recovery range sufficient to accommodate dimensional variation among a plurality of slidably insertable modules.

In various embodiments, the heat transfer assemblies (*e*.*g*., TIM assembly 100 (FIGS. 1-6), 200 (FIG. 8), 300 (FIG. 10), 400 (FIG. 11), *etc.*) disclosed herein may be configured to interface with one or more active or passive cooling structures. Such cooling structures may include, without limitation, liquid-based, phase-change, or conduction-based cooling systems. By way of example, the heat transfer assembly may be operatively coupled to or positioned between a component and a cooling interface comprising a liquid cold plate, a liquid-cooled manifold, a direct-to-chip cold plate, a vapor chamber, a heat pipe, a thermal rail, a chassis-integrated heat spreader, an immersion-cooled interface surface, a refrigerant-cooled plate, a pumped two-phase cooling interface, a rack-level cooling plate, or a door-mounted or sidewall heat exchanger interface. These cooling structures may be implemented individually or in combination and may be integrated at a device level, module level, chassis level, or rack level to facilitate heat transfer from one or more electronic components.

In various embodiments, the resilient contact elements (*e.g*., 116, 120, 216, 316, 320, *etc.)* may be retained, secured, or otherwise positioned within the assembly using a wide range of attachment or integration techniques. Such retention mechanisms may include, without limitation, mechanical fastening approaches such as screws, rivets, or hard-mounted features; adhesive-based attachment including pressure-sensitive adhesives or thermally conductive adhesives; and mechanical retention features such as clips, tabs, hooks, snap-fit features, crimped regions, or self-locking geometries. In further embodiments, the resilient contact elements may be joined or integrated through processes including welding, soldering, brazing, lamination, overmolding, insert molding, or heat staking. Retention may also be achieved through magnetic coupling or by mechanical interlock with adjacent structures, such as a cold plate, cage, chassis, or carrier. The foregoing retention approaches may be used individually or in combination and may provide either permanent or removable attachment. In some embodiments, the resilient contact elements may be partially or fully integrated into surrounding structures, such that separate retention features are minimized or eliminated. It should be understood that the retention methods described herein are exemplary and non-limiting, and that any technique capable of positioning and maintaining the resilient contact elements in operative engagement within the assembly is contemplated.

In exemplary embodiments, a device comprises a heat transfer assembly (*e*.*g*., TIM assembly 100 (FIGS. 1-6), 200 (FIG. 8), 300 (FIG. 10), 400 (FIG. 11), *etc.*), a first component, and a second component. The first component comprises a solid-state drive module, other hot-swappable module, chassis, optical pluggable module, any type of pluggable module for any application that needs cooling, *etc.* The second component comprises a heat sink, cold plate, active/passive cooling structure, or other heat dissipating/removal structure. The heat transfer assembly is positionable generally between a first component and a second component slidable relative to the first component such that: the first wear-resistant side portion of the wear-resistant layer is between the first thermal interface material and a first surface of the first component; the second wear-resistant side portion of the wear-resistant layer is between the second thermal interface material and a second surface of the second component; and the first and second resilient contact elements are operable for providing spring back functionality for urging the wear-resistant layer and/or the respective first and second thermal interface materials into an initial positioning after the first and second surfaces of the respective first and second components are slidably moved relative to each other.

In exemplary embodiments, a device includes a housing adapted to slidably receive a connector and a heat sink, cold plate, active/passive cooling structure, or other heat dissipating/removal structure. A heat transfer assembly as disclosed herein (*e.g.,* TIM assembly 100, *etc.)* is generally between the connector and the heat sink, cold plate, active/passive cooling structure, or other heat dissipating/removal structure when the connector is slidably received within the housing. The heat transfer assembly defines at least a portion of a thermally-conductive heat path or thermal joint between the connector and the heat sink, cold plate, active/passive cooling structure, or other heat dissipating/removal structure. In such exemplary embodiments, the device may be a small form-factor pluggable (SFP) transceiver. The connector may be a small form-factor pluggable (SFP) cable connector. And the housing may be a small form-factor pluggable (SFP) cage adapted to receive the small form-factor pluggable cable connector. In alternative embodiments, the device may comprise a solid-state drive module, other hot-swappable module, chassis, optical pluggable module, any type of pluggable module for any application that needs cooling, *etc.*

Aspects of the present disclosure are not limited to use with any one particular type of device. The thermal interface material assemblies disclosed herein may be used with a wide range of devices including a connector plug, a slidable part of a tablet or other modular portable device, a cage of a transceiver, such as a small form-factor pluggable (SFP) transceiver, SFP+ transceiver, quad small form-factor pluggable (QSFP) transceiver, QSFP+ transceiver, XFP transceiver, Octal Small Form Factor Pluggable (OSFP) transceivers, *etc.*

The heat transfer assemblies (*e*.*g*., TIM assembly 100 (FIGS. 1-6), 200 (FIG. 8), 300 (FIG. 10), 400 (FIG. 11), *etc.*) disclosed herein are preferably configured to have a reusable, recoverable sliding thermal interface architecture for hot-swappable or slidably insertable data center modules, OSFP-RHS/OSFP/QSFP/SFP optical modules, E1.S/E1.L/E3.S/E3.L storage and memory modules, SSDs, CXL memory, accelerator modules, networking modules, power modules, and other field-replaceable modules that slidably engage a cooling structure and/or that are slidably insertable into a port, cage, chassis, bay, rack, guide, or housing.

In exemplary embodiments, a heat transfer assembly or TIM assembly is used with a dynamic random-access memory (DRAM) component is on a fifth generation double data rate (DDR5) dual in-line memory module (DIMM) and a heat sink, cold plate, active/passive cooling structure, or other heat dissipating/removal structure. In such exemplary embodiments, the first and second resilient contact elements are operable for providing spring back functionality for urging and/or retaining the wear-resistant layer and the respective first and second thermal interface materials into their initial positioning after the DDR5 DIMM has been slidably removed from the device. The first and second resilient contact elements are also operable for providing spring back functionality for urging and/or retaining the wear-resistant layer and the respective first and second thermal interface materials into their initial positioning after the DDR5 DIMM has been slidably inserted into position within the device. At which point, a thermally-conductive heat path or thermal joint is defined from the DRAM component through the wear-resistant layer, the first and second resilient contact elements, and the first and second thermal interface materials to the heat sink, cold plate, active/passive cooling structure, or other heat dissipating/removal structure.

In exemplary embodiments, a device/system/port includes a heat transfer assembly or TIM assembly as disclosed herein. The heat transfer assembly may be mounted on the cooling-structure side or on the module side. Or the heat transfer assembly may be integrated into a cage/chassis/port, *etc.* As another example, the Heat transfer assembly may be standalone part to be integrated into the assembly. Also disclosed herein are exemplary methods of repeatedly inserting/removing and cooling a sliding module while the Heat transfer assembly compresses and recovers.

In certain embodiments, a method of thermally coupling an electronic module to a cooling structure is provided. The method may include providing a module port, cold plate, or other receiving structure including a recoverable heat transfer assembly or thermal interface material (TIM) assembly comprising one or more resilient contact elements. An electronic module may be inserted or slid into the port, thereby engaging the heat transfer assembly. During insertion, the resilient contact elements may compress in response to contact with the module, establishing mechanical compliance and conformal engagement. Heat generated by the electronic module may be transferred through one or more layers, including a wear-resistant layer, the TIM, and the resilient contact elements, to the associated cooling structure. Upon removal of the electronic module, the resilient contact elements may at least partially recover toward their original configuration, thereby maintaining readiness for subsequent insertion cycles.

In further embodiments, a method of accommodating dimensional variation and tolerance stack-up in a modular electronic system is provided. The method may include inserting a plurality of electronic modules, each having potentially different dimensional profiles, into one or more module ports containing compliant heat transfer assemblies. As each module is inserted, the resilient contact elements may compress by varying amounts corresponding to differences in module thickness, flatness, or alignment. Despite such variation, the heat transfer assembly maintains continuous thermal contact between the module and an associated cooling interface. In this manner, the compliant characteristics of the heat transfer assembly compensate for tolerance stack-up, including variations in module dimensions, port geometry, and surface conditions, without requiring adjustment or modification of individual components.

In still further embodiments, a method of reusing a heat transfer assembly is provided. The method may include repeatedly inserting and removing one or more electronic modules into and from a port or receiving structure containing a heat transfer assembly without replacing the heat transfer assembly between insertion cycles. The resilient contact elements and associated materials may withstand repeated compression and recovery while maintaining mechanical integrity and thermal performance. As a result, consistent thermal coupling may be achieved over multiple insertion and removal cycles, thereby reducing maintenance requirements and improving system reliability.

In exemplary embodiments, a heat transfer assembly (*e*.*g*., a thermal interface material (TIM) assembly, *etc.*) is a configured as a standalone thermal interface structure positionable between a first component and a second component. The heat transfer assembly comprises a compliant body including one or more resilient contact elements configured to elastically deform under compressive load and recover upon removal of the load. A thermal interface material is disposed in thermal communication with the resilient contact elements. The heat transfer assembly is configured to be compressed between the first component and the second component to establish thermal contact therebetween. The resilient contact elements provide a dimensional tolerance compliance envelope sufficient to accommodate dimensional variation between the first and second components while maintaining thermal performance. In exemplary embodiments, the resilient contact element(s) may provide bulk compliance of the standalone thermal interface structure. A surface coating may be used to reduce thermal contact resistance. The surface coating may be wear-resistant, low-friction, or thermally conductive. The heat transfer assembly may be configured for application as a pad, sheet, *etc.* The heat transfer assembly may or may not be wear or slide resistant.

In exemplary embodiments, a heat transfer assembly comprises a wear-resistant layer and one or more resilient contact elements along an inner surface of the wear-resistant layer. The wear-resistant layer defines a sliding contact surface that protects underlying element(s) from direct shear when the sliding contact surface of the wear-resistant layer slides along and in contact with a surface; and/or the one or more resilient contact elements are configured to be operable for providing spring back functionality for urging and/or retaining the wear-resistant layer into its initial positioning. The heat transfer assembly comprises a mechanically compliant structure defining a dimensional tolerance compliance envelope corresponding to a deflection range. The dimensional tolerance compliance envelope may be configured to accommodate dimensional variation. And the heat transfer assembly is configured to rebound and maintain thermal contact with a surface across the deflection range. In some exemplary embodiments, the heat transfer assembly does not include a separate thermal interface material along the one or more resilient contact element(s) and/or along the inner surface of the wear-resistant layer. in other exemplary embodiments, a thermal interface material is along the one or more resilient contact element(s) and/or along the inner surface of the wear-resistant layer. In which case, the sliding contact surface defined by the wear-resistant layer protects the thermal interface material from direct shear when the sliding contact surface of the wear-resistant layer slides along and in contact with a surface; and/or the one or more resilient contact elements are configured to be operable for providing spring back functionality for urging and/or retaining the thermal interface material into its initial positioning.

Various aspects of the invention according to the present disclosure include, but are not limited to, the aspects listed in the following numbered clauses.

Clause 1: A heat transfer assembly (*e*.*g*., thermal interface material (TIM) assembly, *etc.*) comprising: a wear-resistant layer; one or more resilient contact elements along an inner surface of the wear-resistant layer; and a thermal interface material along the one or more resilient contact element(s) and/or along the inner surface of the wear-resistant layer; wherein the wear-resistant layer defines a sliding contact surface that protects the thermal interface material from direct shear when the sliding contact surface of the wear-resistant layer slides along and in contact with a surface; and/or wherein the one or more resilient contact elements are configured to be operable for providing spring back functionality for urging and/or retaining the wear-resistant layer and the thermal interface material into their initial positioning.

Clause 2: The heat transfer assembly of any preceding clause, wherein the heat transfer assembly is configured for use generally between a first component and a second component slidable relative to the first component such that: the sliding contact surface defined by the wear-resistant layer protects the thermal interface material from direct shear when the sliding contact surface of the wear-resistant layer slides along and in contact with a surface when the first and second components are slidably moved relative to each other; and the one or more resilient contact elements are configured to be operable for providing spring back functionality for urging and/or retaining the wear-resistant layer and the thermal interface material into an initial positioning after the first and second components are slidably moved relative to each other.

Clause 3: The heat transfer assembly of any preceding clause, wherein: the heat transfer assembly comprises a mechanically compliant structure defining a dimensional tolerance compliance envelope corresponding to a deflection range; the dimensional tolerance compliance envelope is configured to accommodate dimensional variation; and the heat transfer assembly is configured to rebound and maintain thermal contact (*e.g.,* perform well, *etc.*) with a surface across the deflection range.

Clause 4: The heat transfer assembly of clause 3, wherein: the dimensional tolerance compliance envelope corresponds to a dimensional tolerance range of a component against ±0 to 5 mm height discrepancy to thereby accommodate different component heights from ±0 to 10 mm (*e*.*g*., ± 0 to 0.1mm, or ±0.1 to 0.5mm, or ±0 to 1.0mm, *etc*.); and/or the heat transfer assembly maintains thermal performance after repeated insertion and removal cycles.

Clause 5: The heat transfer assembly of clauses 3 or 4, wherein: the heat transfer assembly comprises a compliant recovery range sufficient to reestablish thermal contact following deformation; and/or the heat transfer assembly elastically deforms within the dimensional tolerance compliance envelope without requiring active mechanical actuation.

Clause 6: The heat transfer assembly of any preceding clause, wherein the one or more resilient contact elements and the thermal interface material are configured to withstand repeated sliding insertion and removal cycles while maintaining a substantially consistent thermal resistance, without requiring replacement of the thermal interface material; and/or wherein the one or more resilient contact elements and the thermal interface material are configured to withstand repeated deflections without sliding while maintaining a substantially consistent thermal resistance, without requiring replacement of the thermal interface material.

Clause 7: The heat transfer assembly of clause 6, wherein: the substantially consistent thermal resistance is maintained over a plurality of insertion and removal cycles; and/or the one or more contact elements are configured to elastically recover after each sliding cycle to maintain contact pressure and thermal performance; and/or the heat transfer assembly is reusable without reapplication, reconditioning, or replacement of the thermal interface material.

Clause 8: The heat transfer assembly of any preceding clause, further comprising at least one seal disposed at least partially along a perimeter of the thermal interface material to inhibit migration of the thermal interface material and retain the thermal interface material within the heat transfer assembly.

Clause 9: The heat transfer assembly of clause 8, wherein: the seal comprises a foam, elastomer, tape or film, or the seal is integrated with the wear-resistant layer or another structural component of the assembly; the seal extends continuously along the perimeter of the thermal interface material; and the seal is configured to accommodate deformation of the thermal interface material during sliding movement. The seal may or may not be thermally conductive.

Clause 10: The heat transfer assembly of any preceding clause, wherein: the one or more resilient contact elements comprise a first resilient contact element(s) along an inner surface of a first wear-resistant side portion of the wear-resistant layer; and the thermal interface material comprises a first thermal interface material along the first resilient contact element(s) and/or along the inner surface of the first wear-resistant side portion of the wear-resistant layer; the first wear-resistant side portion of the wear-resistant layer defines a first sliding contact surface that protects the first thermal interface material from direct shear when the first sliding contact surface of the wear-resistant layer slides along and in contact with a first surface; and the first resilient contact element(s) is configured to be operable for providing spring back functionality for urging and/or retaining the first wear-resistant side portion of the wear-resistant layer and/or the first thermal interface material into their initial positioning.

Clause 11: The heat transfer assembly of clause 10, wherein: the one or more resilient contact elements comprise a second resilient contact element(s) along an inner surface of a second wear-resistant side portion of the wear-resistant layer; and a second thermal interface material is along the second resilient contact element(s) and/or along the inner surface of the second wear-resistant side portion of the wear-resistant layer; the second wear-resistant side portion of the wear-resistant layer defines a second sliding contact surface that protects the second thermal interface material from direct shear when the second sliding contact surface of the wear-resistant layer slides along and in contact with a second surface; and the first and second resilient contact elements are configured to be operable for providing spring back functionality for urging and/or retaining the respective first and second wear-resistant side portions of the wear-resistant layer and/or the respective first and second thermal interface materials into their initial positioning.

Clause 12: The heat transfer assembly of clause 11, wherein the heat transfer assembly is configured such that when the heat transfer assembly is installed on a heat sink, cold plate, substrate, active/passive cooling structure, or heat dissipating/removal structure and positioned generally between a first component and a second component: the first resilient contact element(s) are resiliently biased and compressed between a first surface of the first component and a first surface of the heat sink, cold plate, substrate, active/passive cooling structure, or heat dissipating/removal structure; and the second resilient contact element(s) are resiliently biased and compressed between a second surface of the second component and a second surface of the heat sink, cold plate, substrate, active/passive cooling structure, or heat dissipating/removal structure.

Clause 13: The heat transfer assembly of clause 11, wherein the heat transfer assembly is configured such that when the heat transfer assembly is installed on a heat sink, cold plate, substrate, active/passive cooling structure, or heat dissipating/removal structure and positioned generally between a first component and a second component: the first thermal interface material is compressed between the first wear-resistant side portion of the wear-resistant layer and a first surface of the heat sink, cold plate, substrate, active/passive cooling structure, or heat dissipating/removal structure; and the second thermal interface material is compressed between the second wear-resistant side portion of the wear-resistant layer and a second surface of the heat sink, cold plate, substrate, active/passive cooling structure, or heat dissipating/removal structure.

Clause 14: The heat transfer assembly of clause 11, wherein the heat transfer assembly is configured such that when the heat transfer assembly is installed on a heat sink, cold plate, substrate, or heat dissipating/removal structure and positioned generally between a first component and a second component: the first thermal interface material is compressed between the first wear-resistant side portion of the wear-resistant layer and a first surface of the heat sink, cold plate, substrate, or heat dissipating/removal structure; the second thermal interface material is compressed between the second wear-resistant side portion of the wear-resistant layer and a second surface of the heat sink, cold plate, substrate, or heat dissipating/removal structure; the first resilient contact element(s) are resiliently biased and/or compressed between a first surface of the first component and the first surface of the heat sink, cold plate, substrate, or heat dissipating/removal structure, whereby the first resilient contact element(s) are operable for providing spring back functionality for urging and/or retaining the first wear-resistant side portion of the wear-resistant layer and the first thermal interface material into their initial positioning; and the second resilient contact element(s) are resiliently biased and/or compressed between the second surface of the second component and the second surface of the heat sink, cold plate, substrate, or heat dissipating/removal structure, whereby the second resilient contact element(s) are operable for providing spring back functionality for urging and/or retaining the second wear-resistant side portion of the wear-resistant layer and the second thermal interface material into their initial positioning.

Clause 15: The heat transfer assembly of any one of clause 11 to 14, wherein: the first and second thermal interface materials comprise the same thermal interface material or different thermal interface materials; the first thermal interface material is disposed, dispensed, or applied along and over the first resilient contact element(s) such that the first resilient contact element(s) are covered by and/or embedded within the first thermal interface material; and the second thermal interface material is disposed, dispensed, or applied along and over the second resilient contact element(s) such that the second resilient contact element(s) are covered by and/or embedded within the second thermal interface material

Clause 16: The heat transfer assembly of any one of clauses 11 to 15, wherein: the first resilient contact element(s) comprise a plurality of upwardly facing generally U-shaped resilient contact elements spaced apart along the inner surface of the first wear-resistant side portion of the wear-resistant layer; and the second resilient contact element(s) comprise a plurality of upwardly facing generally U-shaped resilient contact elements spaced apart along the inner surface of the second wear-resistant side portion of the wear-resistant layer.

Clause 17: The heat transfer assembly of any one of clauses 11 to 16, wherein: the first component comprises a heat source of the device; the second component comprises a heat sink, cold plate, substrate, active/passive cooling structure, or heat dissipating/removal structure; the first and second resilient contact elements are operable for providing spring back functionality for urging and/or retaining the wear-resistant layer and the respective first and second thermal interface materials into their initial positioning after the heat source has been slidably removed from the device; and the first and second resilient contact elements are operable for providing spring back functionality for urging and/or retaining the wear-resistant layer and the respective first and second thermal interface materials into their initial positioning relative to the heat source and the heat sink, cold plate, substrate, active/passive cooling structure, or heat dissipating/removal structure after the heat source has been slidably inserted into position within the device, whereby a thermally-conductive heat path or thermal joint is defined from the heat source through the wear-resistant layer, the first and second resilient contact elements, and the first and second thermal interface materials to the heat sink, cold plate, substrate, active/passive cooling structure, or heat dissipating/removal structure.

Clause 18: The heat transfer assembly of any one of clauses 11 to 17, wherein: the first wear-resistant side portion of the wear-resistant layer is configured to slide along and in contact with a first surface of a first component when the heat transfer assembly is along a second surface of a second component and when the first and second surfaces of the respective first and second components are slidably moved relative to each other; and/or the second wear-resistant side portion of the wear-resistant layer is configured to slide along and in contact with the second surface of the second component when the heat transfer assembly is along the first surface of the first component and when the first and second surfaces of the respective first and second components are slidably moved relative to each other.

Clause 19: The heat transfer assembly of any one of clauses 11 to 18, further comprising: a first seal disposed at least partially along a perimeter of the first thermal interface material to inhibit migration of the first thermal interface material and retain the first thermal interface material within the heat transfer assembly; and a second seal disposed at least partially along a perimeter of the second thermal interface material to inhibit migration of the second thermal interface material and retain the second thermal interface material within the heat transfer assembly.

Clause 20: The heat transfer assembly of any preceding clause, wherein: the one or more resilient contact elements are thermally-conductive and configured to be operable for providing a thermally-conductive heat path or thermal joint between the wear-resistant layer and the thermal interface material; and/or the thermal interface material is disposed, dispensed, or applied along and over the one or more resilient contact elements such that the one or more resilient contact element(s) are covered by and/or embedded within the thermal interface material.

Clause 21: The heat transfer assembly of any preceding clause, wherein the wear-resistant layer is configured to be draped over a heat sink, cold plate, substrate, active/passive cooling structure, or heat dissipating/removal structure such that the wear-resistant layer extends over and along an upper surface and first and second sides of the heat sink, cold plate, substrate, active/passive cooling structure, or heat dissipating/removal structure, whereby the wear-resistant layer defines a generally inverted U-shape over the heat sink, cold plate, substrate, active/passive cooling structure, or heat dissipating/removal structure.

Clause 22: The heat transfer assembly of any preceding clause, wherein the one or more resilient contact element(s) comprise a plurality of upwardly facing generally U-shaped resilient contact elements spaced apart along the inner surface of the wear-resistant layer.

Clause 23: The heat transfer assembly of any preceding clause, wherein the wear-resistant layer comprises: a polyimide-copper clad material in which the polyimide is deposited directly on or bonded to a surface of the copper; or a metal foil or film (or other electrically-conductive foil or film) without an electrically-insulating layer thereon; or a metal foil or film (or other electrically-conductive foil or film) including an electrically-insulating layer thereon; or a copper clad, stainless steel clad, steel clad, or other metal clad having a thickness within a range from about 10 microns to about 250 microns, and an electrically-insulating material or a non-dielectric material thereon having a thickness within a range from about 7.5 microns to about 100 microns or from about 0.5 microns to 250 microns.

Clause 24: The heat transfer assembly of any preceding clause, wherein heat transfer assembly includes: a secondary layer on the wear-resistant layer that is electrically insulating; and/or a secondary layer on the wear-resistant layer that is not electrically insulating.

Clause 25: The heat transfer assembly of any preceding clause, wherein the wear-resistant layer comprises a non-metal foil that is tear resistant, puncture resistant, has a high thermal conductivity, and/or has a thickness within a range from about 10 microns to 250 microns.

Clause 26: The heat transfer assembly of any preceding clause, wherein the one or more resilient contact elements comprise stamped resilient contact elements stamped from stainless steel, beryllium copper, other metal material, or non-metal material.

Clause 27: The heat transfer assembly of any preceding clause, wherein: the thermal interface material has a thermal conductivity within a range from about 1 Watt per meter per Kelvin (W/mK) to about 50 W/mK as determined by ASTM D5470; and/or the thermal interface material comprises a thermal gel, a thermal gap filler pad, a thermal phase change material, a thermal putty, a thermal grease, and/or a dispensable thermal interface material.

Clause 28: The heat transfer assembly of any preceding clause, wherein the heat transfer assembly is configured to provide one or more of: increased durability for withstanding insertions of a heat dissipating module and recover after removal, ensuring repeatable thermal resistance over the numerous insertion and removal cycles; improved reusability with spring-back properties that enables repeatable thermal performance over many insertions; and low thermal resistance for a sliding interface thermal interface material.

Clause 29: The heat transfer assembly of any preceding clause, wherein the heat transfer assembly is configured such that the resulting thermal performance is less than 20 cm² - °C/W. For example, the heat transfer assembly may be configured such that the resulting thermal performance is less than 10 cm² - °C/W. Or, for example, the heat transfer assembly may be configured such that the resulting thermal performance is less than 6 cm² - °C/W for a 10 millimeter x 10 millimeter area. And thermal performance of the heat transfer assembly may be substantially maintained and does not degrade when bond line thickness is cycled between 1.1 millimeters (mm), 1.0 mm, and released to 1.4 mm at the beginning of each cycle when measured on an ASTM D5470 thermal resistance fixture.

Clause 30: The heat transfer assembly of any preceding clause, wherein the wear-resistant layer is configured to have a lower coefficient of friction than the thermal interface material.

Clause 31: The heat transfer assembly of any preceding clause, wherein: the heat transfer assembly is attached to or retained by a cooling structure comprising a cold plate, heat sink, chassis, cage, port wall, or thermal rail; or the heat transfer assembly is attached to a component selected from a sliding module, memory module, solid-state drive (SSD), optical transceiver, accelerator, or other hot-swappable electronic module; or the heat transfer assembly is integrated into a structural feature selected from a module port, cage, guide rail, housing, chassis, or electromagnetic interference (EMI) cage; or the heat transfer assembly is configured to engage multiple opposing surfaces by wrapping around or contacting two or more faces of at least one of a module or a cooling structure; or the heat transfer assembly comprises a standalone and replaceable component configured as an insert retained within a port or on a cooling structure; or the heat transfer assembly comprises a standalone and replaceable component that comprises a liner, sleeve, cartridge, strip, rail, or clip; or the heat transfer assembly comprises a standalone and replaceable component that is removably retained to enable replacement or servicing without disassembly of the cooling structure; or the heat transfer assembly comprises a modular unit configured for integration into multiple form factors; or the heat transfer assembly comprises a modular unit configured to be fastened, inserted, or otherwise integrated during system assembly at a manufacturing or integration site.

Clause 32: The heat transfer assembly of any preceding clause, wherein the wear-resistant layer is configured to provide lateral heat spreading to distribute heat across a surface of the wear-resistant layer; and/or wherein the wear-resistant layer comprises a material having in-plane thermal conductivity greater than through-plane thermal conductivity to facilitate heat spreading. The wear-resistant layer may distribute heat from localized regions of the first thermal interface material to a broader area of the first component.

Clause 33: The heat transfer assembly of any preceding clause, wherein the wear-resistant layer comprises an anisotropic material having one or more different property(ies) in at least a first direction and a second direction. For example, the wear-resistant layer may comprise an anisotropic material having different thermal conductivity in at least a first direction and a second direction. In which case, the anisotropic material may exhibit greater in-plane thermal conductivity than through-plane thermal conductivity.

Clause 34: The heat transfer assembly of any preceding clause, wherein the heat transfer assembly is configured to be operable for providing EMI shielding. For example, the heat transfer assembly may be configured to be disposed (*e.g.,* slidably disposed or sleeved, *etc*.) on the device or applied to the system to "seal" open areas posing risk to EMI leakage.

Clause 35: The heat transfer assembly of any preceding clause, wherein the heat transfer assembly is configured as a standalone, compressible thermal interface structure positionable between two components without requiring attachment or draping over a heat sink, cold plate, substrate, or heat dissipating/removal structure. In which case, the resilient contact element(s) may provide bulk compliance of the standalone thermal interface structure. A surface coating may be used to reduce thermal contact resistance. The surface coating may be wear-resistant, low-friction, or thermally conductive. The heat transfer assembly may be configured for application as a pad, sheet, *etc.* The heat transfer assembly may or may not be wear or slide resistant.

Clause 36: A device comprising the heat transfer assembly of any one of clauses 1 to 35, a first component, and a second component, wherein: the first component comprises a solid-state drive module, a chassis, or a hot-swappable or slidably insertable data center module requiring thermal coupling to an active or passive cooling structure; the second component comprises a heat sink, cold plate, substrate, active/passive cooling structure, or heat dissipating/removal structure; the sliding contact surface defined by the wear-resistant layer protects the thermal interface material from direct shear when the sliding contact surface of the wear-resistant layer slides along and in contact with a surface when the first and second components are slidably moved relative to each other; and the one or more resilient contact elements are configured to be operable for providing spring back functionality for urging and/or retaining the wear-resistant layer and the thermal interface material into an initial positioning after the first and second components are slidably moved relative to each other.

Clause 37: A device comprising: the heat transfer assembly of any one of clauses 1 to 35; a housing adapted to slidably receive a connector; and a heat sink, cold plate, substrate, active/passive cooling structure, or heat dissipating/removal structure; wherein the heat transfer assembly is generally between the connector and the heat sink, cold plate, substrate, active/passive cooling structure, or heat dissipating/removal structure when the connector is slidably received within the housing whereby the heat transfer assembly defines at least a portion of a thermally-conductive heat path or thermal joint between the connector and the heat sink, cold plate, substrate, active/passive cooling structure, or heat dissipating/removal structure.

Clause 38: The device of clause 37, wherein: the device is a small form-factor pluggable transceiver; the connector is a small form-factor pluggable cable connector; and the housing is a small form-factor pluggable cage adapted to receive the small form-factor pluggable cable connector.

Clause 39: A device comprising the heat transfer assembly of any one of clauses 1 to 35, a first component, and a second component, wherein: the first component comprises a dynamic random-access memory (DRAM) component on a fifth generation double data rate (DDR5) dual in-line memory module (DIMM); the second component comprises a heat sink, cold plate, substrate, active/passive cooling structure, or heat dissipating/removal structure; the sliding contact surface defined by the wear-resistant layer protects the thermal interface material from direct shear when the sliding contact surface of the wear-resistant layer slides along and in contact with a surface when the first and second components are slidably moved relative to each other; and the one or more resilient contact elements are configured to be operable for providing spring back functionality for urging and/or retaining the wear-resistant layer and the thermal interface material into an initial positioning after the first and second components are slidably moved relative to each other.

Clause 40: The device of clause 39 when referring to any of clauses 11-19, wherein: the first and second resilient contact elements are operable for providing spring back functionality for urging and/or retaining the wear-resistant layer and the respective first and second thermal interface materials into their initial positioning relative to the heat sink, cold plate, substrate, active/passive cooling structure, or heat dissipating/removal structure after the DDR5 DIMM has been slidably removed from the device; and the first and second resilient contact elements are operable for providing spring back functionality for urging and/or retaining the wear-resistant layer and the respective first and second thermal interface materials into their initial positioning relative to the DRAM component and the heat sink, cold plate, substrate, active/passive cooling structure, or heat dissipating/removal structure after the DDR5 DIMM has been slidably inserted into position within the device, whereby a thermally-conductive heat path or thermal joint is defined from the DRAM component through the wear-resistant layer, the first and second resilient contact elements, and the first and second thermal interface materials to the heat sink, cold plate, substrate, active/passive cooling structure, or heat dissipating/removal structure.

Clause 41: A system comprising a plurality of module ports, each module port including a heat transfer assembly of any one of clauses 1 to 35 that has a compliant recovery range sufficient to accommodate dimensional variation among a plurality of slidably insertable modules.

Clause 42: A module interface system comprising: a receiving structure configured to accept a plurality of electronic modules; and a heat transfer assembly of any one of clauses 1 to 35 that defines a dimensional tolerance compliance envelope that decouples thermal contact performance from dimensional variability of the electronic modules; wherein the dimensional tolerance compliance envelope enables consistent thermal coupling across a range of mechanical tolerances.

Clause 43: A system comprising: a plurality of module ports configured to receive corresponding electronic modules; and a heat transfer assembly of any one of clauses 1 to 35 disposed within each module port; wherein each heat transfer assembly comprises a mechanically compliant structure defining a dimensional tolerance compliance envelope corresponding to a predefined tolerance range; wherein the dimensional tolerance compliance envelope is configured to accommodate dimensional variation between the module ports and the electronic modules and define an allowable insertion envelope for electronic modules received by the module ports; and wherein the heat transfer assembly is configured to maintain thermal contact with the electronic modules across the predefined tolerance range.

Clause 44: The system of any one of clauses 41 to 43, wherein the dimensional tolerance compliance envelope corresponds to: a dimensional tolerance range of at least ±0.10 mm; or a dimensional tolerance range between approximately ±0.10 mm and ±0.25 mm; or a dimensional tolerance range greater than ±0.25 mm. The dimensional tolerance compliance envelope may correspond to a dimensional tolerance range of a component against ±0 to 5 mm height discrepancy to thereby accommodate different component heights from ±0 to 10 mm (*e*.*g*., ± 0 to 0.1mm, or ±0.1 to 0.5mm, or ±0 to 1.0mm, *etc.*)

Clause 45: The system of any one of clauses 41 to 44, wherein the heat transfer assembly is configured to accommodate one or more of: tolerance stack-up, gap variation, module-to-module dimensional variation, port-to-port dimensional variation, surface non-flatness, bow, warp, coplanarity error, tilt, step height variation, surface roughness, and variation in bond line thickness.

Clause 46: The system of any one of clauses 41 to 45, wherein: the heat transfer assembly maintains thermal performance after repeated insertion and removal cycles of the electronic modules; the heat transfer assembly comprises a compliant recovery range sufficient to reestablish thermal contact following deformation; and the heat transfer assembly elastically deforms within the dimensional tolerance compliance envelope without requiring active mechanical actuation.

Clause 47: The system of any one of clauses 41 to 46, wherein: the dimensional tolerance compliance envelope reduces required manufacturing tolerances of the module ports and the electronic modules; the dimensional tolerance compliance envelope reduces or eliminates the need for per-module shimming, thermal pad replacement, or manual adjustment; and/or the dimensional tolerance compliance envelope enables multiple modules having differing dimensions to be interchangeably received within a common module port without modification.

Clause 48: The system of any one of clauses 41 to 47, wherein each module port includes a heat transfer assembly defining a respective dimensional tolerance compliance envelope, and wherein: the dimensional tolerance compliance envelopes of different module ports are identical; or at least one module port comprises a dimensional tolerance compliance envelope different from another module port.

Example embodiments are provided so that this disclosure will be thorough and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i.e.,* the disclosure of a first value and a second value for a given parameter can be interpreted as disclosing that any value between the first and second values could also be employed for the given parameter). For example, if Parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. For example, when permissive phrases, such as "may comprise", "may include", and the like, are used herein, at least one embodiment comprises or includes the feature(s). As used herein, the singular forms "a", "an" and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance of the particular order discussed or illustrated, unless specifically identified as an order of performance. It is also to be understood that additional or alternative steps may be employed.

When an element or layer is referred to as being "on", "engaged to", "connected to" or "coupled to" another element or layer, it may be directly on, engaged, connected or coupled to the other element or layer, or intervening elements or layers may be present. In contrast, when an element is referred to as being "directly on," "directly engaged to", "directly connected to" or "directly coupled to" another element or layer, there may be no intervening elements or layers present. Other words used to describe the relationship between elements should be interpreted in a like fashion (*e*.*g*., "between" versus "directly between," "adjacent" versus "directly adjacent," *etc.).* As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally", "about", and "substantially" may be used herein to mean within manufacturing tolerances. Or for example, the term "about" as used herein when modifying a quantity of an ingredient or reactant of the invention or employed refers to variation in the numerical quantity that can happen through typical measuring and handling procedures used, for example, when making concentrates or solutions in the real world through inadvertent error in these procedures; through differences in the manufacture, source, or purity of the ingredients employed to make the compositions or carry out the methods; and the like. The term "about" also encompasses amounts that differ due to different equilibrium conditions for a composition resulting from a particular initial mixture. Whether or not modified by the term "about", equivalents to the quantities are included.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath", "below", "lower", "above", "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A heat transfer assembly comprising:
a wear-resistant layer;
one or more resilient contact elements along an inner surface of the wear-resistant layer; and
wherein the wear-resistant layer defines a sliding contact surface that protects underlying element(s) from direct shear when the sliding contact surface of the wear-resistant layer slides along and in contact with a surface; and/or
wherein the one or more resilient contact elements are configured to be operable for providing spring back functionality for urging and/or retaining the wear-resistant layer into its initial positioning.

2. The heat transfer assembly of claim 1, wherein:
the heat transfer assembly comprises a mechanically compliant structure defining a dimensional tolerance compliance envelope corresponding to a deflection range;
the dimensional tolerance compliance envelope is configured to accommodate dimensional variation; and
the heat transfer assembly is configured to rebound and maintain thermal contact with a surface across the deflection range after repeated insertion and removal cycles; and
the dimensional tolerance compliance envelope corresponds to a dimensional tolerance range of a component against ±0 to 5 mm height discrepancy to thereby accommodate different component heights from ±0 to 10 mm.

3. The heat transfer assembly of any preceding claim, wherein a thermal interface material is along the one or more resilient contact element(s) and/or along the inner surface of the wear-resistant layer, and wherein:
the sliding contact surface defined by the wear-resistant layer protects the thermal interface material from direct shear when the sliding contact surface of the wear-resistant layer slides along and in contact with a surface; and/or
the one or more resilient contact elements are configured to be operable for providing spring back functionality for urging and/or retaining the thermal interface material into its initial positioning.

4. The heat transfer assembly of claim 3, wherein:
the thermal interface material has a thermal conductivity within a range from 1 W/mK to 50 W/mK as determined by ASTM D5470;
the thermal interface material comprises a thermal gel, a thermal gap filler pad, a thermal phase change material, a thermal putty, a thermal grease, and/or a dispensable thermal interface material;
the wear-resistant layer is configured to have a lower coefficient of friction than the thermal interface material; and
the heat transfer assembly is configured for use generally between a first component and a second component slidable relative to the first component such that:
the sliding contact surface defined by the wear-resistant layer protects the thermal interface material from direct shear when the sliding contact surface of the wear-resistant layer slides along and in contact with a surface when the first and second components are slidably moved relative to each other; and
the one or more resilient contact elements are configured to be operable for providing spring back functionality for urging and/or retaining the wear-resistant layer and the thermal interface material into an initial positioning after the first and second components are slidably moved relative to each other.

5. The heat transfer assembly of any one of claims 3 to 4, wherein:
the one or more resilient contact elements and the thermal interface material are configured to withstand repeated sliding insertion and removal cycles and/or withstand repeated deflection without sliding while maintaining a substantially consistent thermal resistance, without requiring replacement of the thermal interface material;
the one or more resilient contact elements are thermally-conductive and configured to be operable for providing a thermally-conductive heat path or thermal joint between the wear-resistant layer and the thermal interface material;
the thermal interface material is disposed, dispensed, or applied along and over the one or more resilient contact elements such that the one or more resilient contact element(s) are covered by and/or embedded within the thermal interface material;
the one or more contact elements are configured to elastically recover after each sliding cycle to maintain substantially consistent contact pressure and thermal performance; and
the heat transfer assembly is reusable without reapplication, reconditioning, or replacement of the thermal interface material.

6. The heat transfer assembly of any one of claims 3 to 5, further comprising at least one seal disposed at least partially along a perimeter of the thermal interface material to inhibit migration of the thermal interface material and retain the thermal interface material within the heat transfer assembly; and
wherein:
the seal comprises a foam, elastomer, tape or film, or the seal is integrated with the wear-resistant layer or another structural component of the heat transfer assembly; and/or
the seal extends continuously along the perimeter of the thermal interface material; and/or
the seal is configured to accommodate deformation of the thermal interface material during sliding movement.

7. The heat transfer assembly of any one of claims 3 to 6, wherein:
the one or more resilient contact elements comprise a first resilient contact element(s) along an inner surface of a first wear-resistant side portion of the wear-resistant layer and a second resilient contact element(s) along an inner surface of a second wear-resistant side portion of the wear-resistant layer;
the thermal interface material comprises a first thermal interface material along the first resilient contact element(s) and/or along the inner surface of the first wear-resistant side portion of the wear-resistant layer and a second thermal interface material is along the second resilient contact element(s) and/or along the inner surface of the second wear-resistant side portion of the wear-resistant layer;
the first wear-resistant side portion of the wear-resistant layer defines a first sliding contact surface that protects the first thermal interface material from direct shear when the first sliding contact surface of the wear-resistant layer slides along and in contact with a first surface;
the second wear-resistant side portion of the wear-resistant layer defines a second sliding contact surface that protects the second thermal interface material from direct shear when the second sliding contact surface of the wear-resistant layer slides along and in contact with a second surface; and
the first and second resilient contact elements are configured to be operable for providing spring back functionality for urging and/or retaining the respective first and second wear-resistant side portions of the wear-resistant layer and/or the respective first and second thermal interface materials into their initial positioning.

8. The heat transfer assembly of claim 7, wherein the heat transfer assembly is configured such that when the heat transfer assembly is installed on a heat sink, cold plate, substrate, or heat dissipating/removal structure and positioned generally between a first component and a second component:
the first thermal interface material is compressed between the first wear-resistant side portion of the wear-resistant layer and a first surface of the heat sink, cold plate, substrate, or heat dissipating/removal structure;
the second thermal interface material is compressed between the second wear-resistant side portion of the wear-resistant layer and a second surface of the heat sink, cold plate, substrate, or heat dissipating/removal structure;
the first resilient contact element(s) are resiliently biased and/or compressed between a first surface of the first component and the first surface of the heat sink, cold plate, substrate, or heat dissipating/removal structure, whereby the first resilient contact element(s) are operable for providing spring back functionality for urging and/or retaining the first wear-resistant side portion of the wear-resistant layer and the first thermal interface material into their initial positioning; and
the second resilient contact element(s) are resiliently biased and/or compressed between the second surface of the second component and the second surface of the heat sink, cold plate, substrate, or heat dissipating/removal structure, whereby the second resilient contact element(s) are operable for providing spring back functionality for urging and/or retaining the second wear-resistant side portion of the wear-resistant layer and the second thermal interface material into their initial positioning.

9. The heat transfer assembly of claim 7 or 8, wherein:
the first resilient contact element(s) comprise a plurality of upwardly facing generally U-shaped resilient contact elements spaced apart along the inner surface of the first wear-resistant side portion of the wear-resistant layer;
the second resilient contact element(s) comprise a plurality of upwardly facing generally U-shaped resilient contact elements spaced apart along the inner surface of the second wear-resistant side portion of the wear-resistant layer;
the first and second thermal interface materials comprise the same thermal interface material or different thermal interface materials;
the first thermal interface material is disposed, dispensed, or applied along and over the first resilient contact element(s) such that the first resilient contact element(s) are covered by and/or embedded within the first thermal interface material; and
the second thermal interface material is disposed, dispensed, or applied along and over the second resilient contact element(s) such that the second resilient contact element(s) are covered by and/or embedded within the second thermal interface material.

10. The heat transfer assembly of claim 8 or 9, wherein:
the first component comprises a heat source of a device;
the second component comprises a heat sink, cold plate, substrate, active/passive cooling structure, or heat dissipating/removal structure;
the first and second resilient contact elements are operable for providing spring back functionality for urging and/or retaining the wear-resistant layer and the respective first and second thermal interface materials into their initial positioning after the heat source has been slidably removed from the device; and
the first and second resilient contact elements are operable for providing spring back functionality for urging and/or retaining the wear-resistant layer and the respective first and second thermal interface materials into their initial positioning relative to the heat source and the heat sink, cold plate, substrate, active/passive cooling structure, or heat dissipating/removal structure after the heat source has been slidably inserted into position within the device, whereby a thermally-conductive heat path or thermal joint is defined from the heat source through the wear-resistant layer, the first and second resilient contact elements, and the first and second thermal interface materials to the heat sink, cold plate, substrate, active/passive cooling structure, or heat dissipating/removal structure.

11. The heat transfer assembly of any one of claims 7 to 10, wherein the heat transfer assembly further comprises a first seal disposed at least partially along a perimeter of the first thermal interface material to inhibit migration of the first thermal interface material and retain the first thermal interface material within the heat transfer assembly, and a second seal disposed at least partially along a perimeter of the second thermal interface material to inhibit migration of the second thermal interface material and retain the second thermal interface material within the heat transfer assembly; and/or
wherein:
the first wear-resistant side portion of the wear-resistant layer is configured to slide along and in contact with a first surface of a first component when the heat transfer assembly is along a second surface of a second component and when the first and second surfaces of the respective first and second components are slidably moved relative to each other; and
the second wear-resistant side portion of the wear-resistant layer is configured to slide along and in contact with the second surface of the second component when the heat transfer assembly is along the first surface of the first component and when the first and second surfaces of the respective first and second components are slidably moved relative to each other.

12. The heat transfer assembly of any preceding claims, wherein:
the wear-resistant layer is configured to be draped over a heat sink, cold plate, substrate, active/passive cooling structure, or heat dissipating/removal structure such that the wear-resistant layer extends over and along an upper surface and first and second sides of the heat sink, cold plate, substrate, active/passive cooling structure, or heat dissipating/removal structure, whereby the wear-resistant layer defines a generally inverted U-shape over the heat sink, cold plate, substrate, active/passive cooling structure, or heat dissipating/removal structure; and/or
the one or more resilient contact element(s) comprise a plurality of upwardly facing generally U-shaped resilient contact elements spaced apart along the inner surface of the wear-resistant layer; and/or
the heat transfer assembly is configured as a standalone, compressible thermal interface structure positionable generally between two components without requiring attachment or draping over a heat sink, cold plate, substrate, or heat dissipating/removal structure.

13. The heat transfer assembly of any preceding claim, wherein:
the heat transfer assembly includes a secondary layer on the wear-resistant layer that is electrically insulating or that is not electrically insulating; and/or
the one or more resilient contact elements comprise stamped resilient contact elements that are stamped from metal material or non-metal material; and/or
the wear-resistant layer comprises:
a polyimide-copper clad material in which the polyimide is deposited directly on or bonded to a surface of the copper; or
electrically-conductive foil or film without an electrically-insulating layer thereon; or
electrically-conductive foil or film including an electrically-insulating layer thereon; or
a metal clad having a thickness within a range from 10 microns to 250 microns, and an electrically-insulating material or a non-dielectric material thereon having a thickness within a range from 7.5 microns to 100 microns or from 0.5 microns to 250 microns; or
the wear-resistant layer comprises a non-metal foil that is tear resistant, puncture resistant, and/or has a thickness within a range from 10 microns to 250 microns.

14. The heat transfer assembly of any preceding claim, wherein:
the wear-resistant layer is configured to provide lateral heat spreading to distribute heat across a surface of the wear-resistant layer; and/or
the wear-resistant layer comprises a material having in-plane thermal conductivity greater than through-plane thermal conductivity to facilitate heat spreading; and/or
the wear-resistant layer comprises an anisotropic material having one or more different property(ies) in at least a first direction and a second direction; and/or
the heat transfer assembly is configured to be operable for providing EMI shielding.

15. A system comprising:
a plurality of module ports configured to receive corresponding electronic modules;
a heat transfer assembly of any preceding claim disposed within each module port;
wherein:
each heat transfer assembly comprises a mechanically compliant structure defining a dimensional tolerance compliance envelope corresponding to a deflection range;
the dimensional tolerance compliance envelope is configured to accommodate dimensional variation between the module ports and the electronic modules and define an allowable insertion envelope for electronic modules received by the module ports;
the heat transfer assembly is configured to rebound and maintain thermal contact with the electronic modules across the deflection range after repeated insertion and removal cycles; and
the dimensional tolerance compliance envelope corresponds to a dimensional tolerance range of a component against ±0 to 5 mm height discrepancy to thereby accommodate different component heights from ±0 to 10 mm.
